# EUROPÄISCHE PATENTSCHRIFT

(11) **EP 3 036 827 B1**
(45) Veröffentlichungstag und Bekanntmachung des Hinweises auf die Patenterteilung: **26.05.2021**
(21) Anmeldenummer: 14780815.8
(22) Anmeldetag: 29.09.2014
(51) Int. Cl.: H02N 2/04, F16F 15/00

(54) **HUBSYSTEM, VERFAHREN ZUR ELEKTRISCHEN PRÜFUNG, SCHWINGUNGSDÄMPFER UND MASCHINENAGGREGAT**
LIFTING SYSTEM, METHOD FOR ELECTRICAL TESTING, VIBRATION DAMPER, AND MACHINE ASSEMBLY
SYSTÈME DE LEVAGE, PROCÉDÉ DE CONTRÔLE ÉLECTRIQUE, AMORTISSEUR DE VIBRATIONS ET GROUPE DE MACHINES

(30) Priorität: 27.09.2013 DE 102013219632; 26.09.2014 DE 102014219604
(43) Veröffentlichungstag der Anmeldung: 29.06.2016
(73) Patentinhaber: Siemens Aktiengesellschaft, 80333 München (DE)
(72) Erfinder: BACHMAIER, Georg, 80469 München (DE); EBELSBERGER, Gerit, 81737 München (DE); GERHARD, Detlef, 81829 München (DE); GÖDECKE, Andreas, 81677 München (DE); ZÖLS, Wolfgang, 81249 München-Lochhausen (DE)
(86) Internationale Anmeldenummer: PCT/EP2014/070803
(87) Internationale Veröffentlichungsnummer: WO 2015/044420

(56) Entgegenhaltungen:
- EP-A2- 0 864 743
- WO-A1-2012/077190
- WO-A1-2013/160398
- WO-A1-2014/001083
- DE-A1- 19 646 847
- DE-C1- 10 100 392
- JP-A- 2008 263 731

## Beschreibung

Die Erfindung betrifft einen Schwingungsdämpfer sowie ein Maschinenaggregat aufweisend einen Schwingungsdämpfer.

Die vorliegende Erfindung betrifft einen Schwingungsdämpfer sowie ein Maschinenaggregat: Beim Betrieb von Maschinen, wie insbesondere großen, Elektromotoren, treten häufig Schwingungen auf, etwa erregt durch Unwuchten, oder auch magnetisch erregt durch einen rotierenden magnetischen Fluss zwischen Rotor und Stator.

Nachteilhaft können solche Schwingungen in ein Fundament einkoppeln und etwa umliegende Installationen zum Schwingen bringen. Zum anderen können die Schwingungen über den Rotor auf eine anzutreibende Anlage (z.B. Verdichter) übertragen werden. Neben Komfortproblemen (Lautstärke, Humanschwingungen) führt dies häufig zu Schäden durch Ermüdungsbrüche.

Es ist bekannt, Schwingungen im Betrieb von Elektromotorendurch Beseitigung der verursachenden Asymmetrien zu vermeiden, etwa durch Wuchten oder durch eine gute magnetische Auslage des Elektromotors. Allerdings sind eine hohe Wuchtgüte und eine hohe Homogenität der Magnetführung technisch begrenzt oder nur sehr teuer umzusetzen.

Ferner ist eine passive Schwingungsreduktion bekannt: So können viskoelastische Dämpferelemente ("Gummidämpfer") am Maschinenfuß vorgesehen sein. Nachteilig können jedoch auch quasistationäre Kräfte, wie sie beispielsweise beim Aufbau von Drehmomenten anliegen, zu Deformationen führen.

Weiterhin ist es, insbesondere im Fahrzeugbau, bekannt, hydraulische Dämpfer einzusetzen, die mittels hydraulischer Drosseln, also passiv, dämpfen. Allerdings können durch Aufbau von Vordruck quasistationäre Kräfte aufgebracht werden, so dass zum Beispiel bei Fahrzeugen aktive Stabilisationsmaßnahmen möglich werden (Electronically controlled active suspension system (ECASS) bspw. Active Body Control bei Mercedes Benz, Active Roll Stabilization bei BMW). Allerdings ist bei traditionellen Systemen, die mit hydraulischen Pumpen arbeiten, die Antwortzeit recht lang bzw. die Grenzfrequenz niedrig (wenige Hz).

Ferner sind magnetorheologische Dämpfer bekannt. Normalerweise erreichen diese jedoch nur eine einstellbare Dämpfungscharakteristik, keine aktive Einbringung von Vorkräften.

Ferner werden in Gebäuden, insbesondere Hochhäusern, oder Brücken, Freileitungen sowie Verbrennungsmotoren Schwingungstilger zur Reduktion von Schwingungen eingesetzt. Schwingungstilger bestehen aus einer Tilgermasse, die mit einer Tilgerfeder sowie einen Dämpfer an das zu dämpfende System angebunden werden. Schwingungstilger entziehen bei ihrer Eigenfrequenz der zu dämpfenden Struktur Schwingungsenergie. Nachteilig erfordern alle Schwingungstilger eine zusätzliche Masse und sind damit teuer und schwer.

Aus DE 101 00 392 C1 ist ein hydraulischer Wegübersetzer zur Vergrößerung des Stellwegs eines zur Ansteuerung einer Ventilnadel eingesetzten Piezostellgliedes bekannt. JP 2008-263731 A und EP 0 864 743 A zeigen weitere Ausführungsformen derartiger hydraulischer Wegübersetzer.

DE 196 46 847 A1 nennt als mögliches, nicht näher spezifiziertes Anwendungsgebiet eines mit einer hydraulischen Wegübersetzung ausgestatteten Stellglieds die aktive Schwingungsdämpfung.

Es ist somit zudem Aufgabe der Erfindung, einen verbesserter Schwingungsdämpfer sowie ein verbessertes Maschinenaggregat bereitzustellen.

Diese Aufgaben werden mit einem Schwingungsdämpfer mit den in Anspruch 1 angegebenen Merkmalen sowie mit einem Maschinenaggregat mit den in Anspruch 11 angegebenen Merkmalen gelöst. Bevorzugte Weiterbildungen der Erfindung sind in den zugehörigen Unteransprüchen, der nachfolgenden Beschreibung und der Zeichnung angegeben.

Das dem erfindungsgemäßen Schwingungsdämpfer zugrundeliegende Hubsystem weist zumindest einen Piezosteller auf. Ferner weist das Hubsystem eine Auflage sowie einen hydraulischen Wegübersetzer mit einer Eingangs- und einer Ausgangsseite auf, wobei der hydraulische Wegübersetzer mit seiner Eingangsseite an den zumindest einen Piezosteller und mit seiner Ausgangsseite an die Auflage angebunden ist. Das Hubsystem vereint somit vorteilhaft zum einen die hohe Dynamik sowie die hohe Positioniergenauigkeit eines Piezostellers als auch zum anderen die Möglichkeit, mittels hydraulischer Wegübersetzer große Hubwege zu erreichen. Gegenüber herkömmlichen Piezostellern können auf diese Weise deutlich längere Hubwege gestellt werden. Gleichzeitig weist das Hubsystem eine sehr hohe Systemsteifigkeit auf, welche deutlich höher ist als bei Hubsystemen, bei welchen Piezostellwege mittels Festkörpergelenken übersetzt werden. Der notwendige Hub des Hubsystems lässt sich folglich besonders schnell und zuverlässig erreichen. Insbesondere bei zeitkritischen Anwendungen lässt sich das Hubsystem daher besonders vorteilhaft einsetzen. Ferner ist das Hubsystem kaum resonant zu mechanischen Eigenresonanzen anregbar. Auch in dieser Hinsicht ist das Hubsystem weitgehend unanfällig.

Bevorzugt ist bei dem Hubsystem der Piezosteller ein Piezosteller mit einer Stellrichtung. Zweckmäßig ist bei dem Hubsystem der hydraulische Wegübersetzer mit seiner Eingangsseite in Stellrichtung an den Piezosteller angebunden. Vorzugsweise ist der Piezosteller ein Multilagen-Piezoaktor. Multilagen-Piezoaktoren können eine hohe Leistungsdichte bei vergleichsweise geringen Versorgungsspannungen bereitstellen.

Vorteilhaft ist die Auflage mit einer, sich insbesondere mit ihrer flächigen Erstreckung quer zur Stellrichtung erstreckenden, Platte gebildet, wobei das Hubsystem bevorzugt einen Hubtisch bildet.

Zweckmäßig umfasst bei dem Hubsystem der hydraulische Wegübersetzer ein- und ausgangsseitig jeweils mindestens eine Kolbenkammer mit einem darin geführten Kolben. Dabei weichen die Querschnitte der zumindest einen eingangsseitigen Kolbenkammer/der Kolbenkammern und der zumindest einen ausgangsseitigen Kolbenkammer/der Kolbenkammern vorzugsweise voneinander ab. Es versteht sich, dass unter einem Querschnitt einer Kolbenkammer ein Schnitt der Kolbenkammer quer, d.h. senkrecht, zu einer Führungsrichtung des in der Kolbenkammer jeweils geführten Kolbens zu verstehen ist.

Alternativ und ebenfalls bevorzugt umfasst bei dem Hubsystem der hydraulische Wegübersetzer ein- und ausgangsseitig jeweils zumindest einen Faltenbalg, wobei die Querschnitte des zumindest einen eingangsseitigen und des zumindest einen ausgangsseitigen Faltenbalgs vorzugsweise voneinander abweichen. Unter einem Querschnitt eines Faltenbalgs ist vorliegend jeweils ein Schnitt quer, d.h. senkrecht, zu einer Faltrichtung des Faltenbalges, d.i. eine Richtung, entlang welcher der Faltenbalg zusammenlegbar ist, zu verstehen. Insbesondere verläuft der Querschnitt parallel zu einer bevorzugt vorgesehenen Falt- oder Knicklinie oder entlang eines umfänglich verlaufenden Wellenberges eines alternativ und ebenfalls bevorzugt vorgesehenen Wellenprofils des Faltenbalgs.

Vorzugsweise weist bei dem Hubsystem der hydraulische Wegübersetzer eingangsseitig zwei oder drei oder vier oder mehr Elemente auf aus der Gruppe, die einen Faltenbalg sowie eine Kolbenkammer mit darin geführtem Kolben umfasst, wobei der hydraulische Wegübersetzer ausgangsseitig demgegenüber weniger Elemente aus der vorgenannten Gruppe, vorzugsweise genau ein Element, aufweist. Zweckmäßig sind die eingangsseitigen Elemente mit dem zumindest einen ausgangsseitigen Element jeweils hydraulisch verbunden.

In einer bevorzugten Weiterbildung des Hubsystems sind die eingangsseitige/n Kolbenkammer/n mit der/den ausgangsseitigen Kolbenkammer/n, insbesondere hydraulisch, verbunden oder es sind der eingangsseitige Faltenbalg oder die eingangsseitigen Faltenbälge mit dem ausgangsseitigen Faltenbalg oder den ausgangsseitigen Faltenbälge, insbesondere hydraulisch, verbunden, vorzugsweise mittels jeweils einer hydraulischen Drossel. Durch die Auslegung der hydraulischen Drossel kann das Dämpfungsverhalten des Hubsystems einfach angepasst werden.

Die zumindest eine eingangsseitige sowie die zumindest eine ausgangsseitige Kolbenkammer, zusammenwirkend mit den jeweils darin geführten Kolben oder aber der zumindest eine eingangsseitige Faltenbalg und der zumindest eine ausgangsseitige Faltenbalg bilden jeweils zweckmäßig Fluidvolumina, wobei die Fluidvolumina miteinander gekoppelt, vorzugsweise verbunden, sind. Geeigneterweise sind die Fluidvolumina mit inkompressiblem Fluid, insbesondere einer Hydraulikflüssigkeit, gefüllt.

Gemäß den zuvor genannten Weiterbildungen wird die hydraulische Übersetzung des hydraulischen Wegübersetzers mittels der ein- und ausgangsseitigen Kolbenkammern und/oder mittels der ein- und ausgangsseitigen Faltenbälge realisiert, die unterschiedliche hydraulische Querschnitte aufweisen und fluidisch miteinander verbunden sind. Aufgrund der Forderung, dass das hydraulische Volumen innerhalb des Wegübersetzers des Hubsystems konstant bleiben muss, ergibt sich die Wegübersetzung des hydraulischen Wegübersetzers als das Verhältnis des eingangsseitigen und des ausgangsseitigen hydraulischen Querschnitts (etwa deren Querschnitte quer zur jeweiligen Führungsrichtung des Kolbens oder quer zur Faltrichtung). Im Falle, dass eingangsseitig mehrere Faltenbälge und/oder Kolbenkammern vorgesehen sind, tritt naturgemäß deren Summe der hydraulischen Querschnitte an die Stelle des zuvor erwähnten eingangsseitigen hydraulischen Querschnitts. Analog ist bei mehreren ausgangsseitig vorgesehenen Faltenbälgen und/oder Kolbenkammern unter dem ausgangsseitigen hydraulischen Querschnitt deren Summe von hydraulischen Querschnitten zu verstehen. Auf diese Weise können durch die eingangsseitige Kolbenbewegung erfolgende Volumenänderungen der eingangsseitigen Kolbenkammer oder durch eingangsseitige Faltung des Faltenbalgs erfolgende Volumenänderungen des eingangsseitigen Faltenbalgs über die hydraulische Verbindung entsprechende Volumenänderungen der ausgangsseitigen Kolbenkammer oder des ausgangsseitigen Faltenbalges bewirken. Folglich resultiert eine besonders präzise Kopplung von Ein- und Ausgangsseite des hydraulischen Wegübersetzers des Hubsystems.

In denjenigen Weiterbildungen des Hubsystems, bei welchen die jeweiligen Fluidvolumina mittels ein- und ausgangsseitiger Faltenbälge realisiert sind, sind die jeweiligen Fluidvolumina überdies metallisch abgedichtet. Dichtigkeitsprobleme solcher Fluidvolumina sind daher von vornherein vermieden. Eine Wegübersetzung wird in diesen Weiterbildungen durch flexible Wellen in den Bälgen und der damit verbundenen geringen axialen Steifigkeit erreicht. Das Fluidvolumen ist dabei bevorzugt so gering wie möglich realisiert, sodass die Steifigkeit des Hubsystems maximiert ist. Vorteilhaft sind die Fluidvolumina abgeschlossen und unterliegen folglich keiner Verschmutzung. Das Hubsystem lässt sich folglich besonders haltbar und wartungsarm ausbilden.

Geeigneterweise sind in den hydraulischen Volumina von Kolbenkammern oder Faltenbälgen jeweils Verdrängungskörper, insbesondere aus Metall, vorgesehen. In diesem Falle ist die Gesamtsteifigkeit des Hubsystems besonders erhöht.

Zweckmäßig ist bei dem Hubsystem der Querschnitt der Kolbenkammer an der Eingangsseite größer als der Querschnitt der Kolbenkammer an der Ausgangsseite oder aber der Querschnitt des Faltenbalgs an der Eingangsseite ist größer als der Querschnitt des Faltenbalgs an der Ausgangsseite. In dieser Weiterbildung ist eine Übersetzung von Stellwegen des Piezostellers in verglichen mit diesen größere Stellwege des Hubsystems gewährleistet.

Bei einem beispielhaften, nicht Teil der Erfindung bildenden Verfahren zur elektrischen Prüfung einer elektronischen Komponente wird die Komponente auf die Auflage eines derartigen Hubsystems wie zuvor beschrieben aufgelegt und zur Positionierung relativ zu einem Prüfkontakt geeignet gehoben oder gesenkt. Mittels des Hubsystems wie zuvor beschrieben wird gleichzeitig eine sehr hohe Systemsteifigkeit erreicht als auch ein erforderlicher Hub sehr schnell bewerkstelligt. Mittels des beispielhaften, nicht erfindungsgemäßen Verfahrens lässt sich folglich eine Testzeit einer elektronischen Komponente deutlich verkürzen, da sowohl die Zeit als auch die Zuverlässigkeit des zur Prüfung erforderlichen Hubs verbessert ist. Ferner ist durch die Hydraulik das Hubsystem stark gedämpft und es entsteht eine "weiche" Hubkurve, mittels welcher die elektronische Komponente besonders behutsam gehoben oder gesenkt werden kann. Eine Positionierung einer elektronischen Komponente relativ zu einem Prüfkontakt ist folglich mittels des Verfahrens besonders bedarfsangepasst möglich. Idealerweise wird das Verfahren zur Prüfung einer elektronischen Komponente in Gestalt einer Leuchtdiode (LED) durchgeführt.

Der erfindungsgemäße Schwingungsdämpfer, weist ein Hubsystem wie zuvor beschrieben auf.

Im Gegensatz zu traditionellen Schwingungstilgern (mit Zusatzmassen) erlaubt der erfindungsgemäße Schwingungsdämpfer einen Einbau direkt zwischen einem Fundament und etwa einem Fuß einer zu dämpfenden Maschine. Sowohl konstruktiv als auch steuer-/regelungstechnisch ist dies ein besonders einfacher, effizienter und robuster Ansatz.

Der Einsatz von Piezostellern zur Schwingungsreduktion ist in der Vergangenheit oft an den geringen Auslenkungen von Piezostellern gescheitert. Mittels des hier vorgestellten mikrohydraulischen Prinzips unter dem Einsatz von erfindungsgemäßen Hubübersetzern und der Kopplung von beliebig vielen Piezostellern an einen ausgangsseitigen Faltenbalg oder eine ausgangsseitige Kolbenkammer mit darin geführtem Kolben ist diese Begrenzung effektiv aufgehoben: Erfindungsgemäß lässt sich eine nahezu beliebige Auslenkung des Hubsystems und des erfindungsgemäßen Schwingungsdämpfers bei nahezu beliebigem Kraftniveau erreichen.

Bevorzugt ist bei dem erfindungsgemäßen Schwingungsdämpfer die Auflage zur form- und/oder stoff- und/oder kraftschlüssigen Verbindung mit einem Teil einer Maschine, insbesondere einem Maschinenfuß, eingerichtet.

In einer vorteilhaften Weiterbildung weist der erfindungsgemäße Schwingungsdämpfer ein Anbindungsstück sowie einen zweiten hydraulischen Wegübersetzer mit einer Eingangs- und einer Ausgangsseite, welcher mit seiner Eingangsseite an einen weiteren Linearaktor und mit seiner Ausgangsseite an das Anbindungsstück angebunden ist, auf.

Auf diese Weise können nicht allein vertikale Schwingungen gedämpft werden, wie es mittels des erfindungsgemäßen Schwingungsdämpfers mit dem Hubsystem der Fall ist, sondern es können zusätzlich Schwingungen in weiteren Freiheitsgraden, etwa Schwingungen in horizontalen Raumrichtungen mittels des zweiten hydraulischen Wegübersetzers mit dem weiteren Linearaktor gedämpft werden.

Erfindungsgemäß umfasst der Schwingungsdämpfer eine Steuereinheit, die ausgebildet ist, den Piezosteller in einer ersten Betriebsart derart anzusteuern, dass die insgesamt auf das Hubsystem wirkende Kraft konstant bleibt und/oder in einer zweiten Betriebsart derart zu steuern, dass die Auflage mit möglichst geringer Auslenkung schwingt.

Bevorzugt ist bei dem erfindungsgemäßen Schwingungsdämpfer anstelle des zumindest einen Piezostellers zumindest ein sonstiger Aktor, insbesondere zumindest ein magnetischer und/oder magnetostriktiver und/oder elektrostriktiver Aktor und/oder ein Aktor, welcher auf dem Formgedächtnis-Prinzip, vorzugsweise dem Prinzip des magnetischen Formgedächtnisses, beruht, vorhanden.

Das erfindungsgemäße Maschinenaggregat weist eine Maschine, insbesondere einen Elektromotor, sowie mindestens einen Schwingungsdämpfer wie zuvor beschrieben auf, welcher, vorzugsweise mittels eines Anbindungsteils, an die Maschine, vorzugsweise zumindest einen Fuß der Maschine, angebunden ist.

Das erfindungsgemäße Maschinenaggregat lässt sich leicht und kompakt ausbilden, etwa indem ein typischer Maschinenfuß mit einem Schwingungsdämpfer versehen wird, was lediglich geringe oder keine Änderungen im Raumbedarf oder Gewicht bedingt. So können erfindungsgemäße Maschinenaggregate mit geringen Änderungen gegenüber nicht schwingungsgedämpften Maschinen ausgebildet sein. Insbesondere ist es nicht notwendig, Platz für große Tilgermassen vorzusehen. Dies kann die Kundenakzeptanz deutlich verbessern. Die Reduktion von Schwingungen der Maschine ist dabei in verschiedenen Varianten möglich. Die Entkopplung von der Maschine des erfindungsgemäßen Maschinenaggregats und einem Fundament, auf welchem die Maschine positioniert ist, verhindert, dass oszillierende Kräfte in das Fundament eingeleitet werden. Die Beruhigung leitet Kräfte derart in die Maschine ein, sodass diese (oder eines oder mehrere ihrer Teile) an Schwingungen gehindert wird. In Mischformen liegt eine Kombination der obigen Merkmale vor, so dass die Schwingung der Maschine oder Teile der Maschine reduziert wird, aber gleichzeitig eine Krafteinleitung ins Fundament in einem akzeptablen Rahmen gehalten wird.

Insbesondere ist erfindungsgemäß zwischen einem Fuß der Maschine und einem Fundament, auf welchem die Maschine positioniert ist, jeweils ein Schwingungsdämpfer vorgesehen. Bei einer Maschine, etwa in Gestalt eines typischen Elektromotors, mit vier Füßen werden also zweckmäßig vier erfindungsgemäße Schwingungsdämpfer eingesetzt; entsprechend handelt sich um ein verteiltes Schwingungsdämpfungssystem.

Vorzugswiese ist bei dem erfindungsgemäßen Schwingungsdämpfer und bei dem erfindungsgemäßen Maschinenaggregat das Hubsystem mit Frequenzen vom statischem Betrieb (0 Hz) bis zu einer Maximalfrequenz, vorzugsweise zumindest 5000 1/min, insbesondere zumindest 10000 1/min, auslenkbar. Geeigneterweise ist das Hubsystem innerhalb des vorgenannten Frequenzbereichs mit einer Auslenkung von bis zu 200 Mikrometern, insbesondere mit einer Auslenkung von bis zu 800 Mikrometern, auslenkbar.

Regelmäßig ist die Maximalfrequenz durch die Maximalbetriebsfrequenz der Maschine (zweckmäßig mindestens 5000 1/min), multipliziert mit der Anzahl der Polpaare (zweckmäßig mindestens 2) etwa eines (Elektro-)Motors der Maschine bestimmt. Die notwendige Maximalauslenkung ergibt sich aus der dynamischen Systemauslegung und ist in erster Linie von der Art des Fundamentes, vor allem von der (fehlenden) Steifigkeit des Fundamentes abhängig.

Typischerweise liegt die notwendige Maximalauslenkung im Bereich von 200 Mikrometern bis 800 Mikrometern. Durch Auslenkung des Hubsystems des erfindungsgemäßen Schwingungsdämpfers wird zwischen dem Fundament und Maschine eine steuer- oder regelbare Auslenkung oder Kraft eingestellt. Auf diese Art und Weise stehen insbesondere die nachfolgend näher beschriebenen Möglichkeiten der Schwingungsreduktion des Maschinenaggregats zur Verfügung, die zweckmäßig in der zuvor beschriebenen Steuereinrichtung realisiert sind:
1. Entkopplung:
   Die Schwingung der Maschine wird vom Fundament entkoppelt, d.h. das Fundament wird lediglich quasistationären Kräften (Gewicht der Maschine und/oder quasistationärer Drehmomentbelastung) ausgesetzt. Hierfür wird die Auslenkung der Piezosteller zweckmäßigerweise so gesteuert und/oder geregelt, dass die Kraft auf die Piezosteller und/oder auf die Ausgangsseite des hydraulischen Wegübersetzers möglichst konstant ist. Hierfür sind vorteilhafterweise Kraftsensoren in die Piezosteller und/oder die hydraulischen Wegübersetzer integriert. Die Maschine kann so quasi frei schwingen. Die Motorschwingung wird so zwar gegenüber dem ungedämpften System nicht reduziert. Allerdings werden die in die Umgebung eingekoppelten Schwingungen unterdrückt bzw. erheblich reduziert, was in Hinsicht auf Lärmbelastung oder Humanschwingungen vorteilhaft ist.
2. Beruhigung:
   Die Auslenkungen der Piezosteller werden so angesteuert, dass die Maschine oder Teile der Maschine, insbesondere ein Motorblock oder ein Motorschild oder ein Motorlager oder ein Rotor oder eine Achse eines Elektromotors, an ihren Schwingungen gehindert, d.h. gewissermaßen "gefesselt" wird oder werden. Hierfür müssen Kräfte eingekoppelt werden, die im Wesentlichen den Anregungskräften entgegengesetzt, aber gleich groß gewählt sind. Vorteilhafterweise werden hierfür Sensoren an den zu beruhigenden Teilen angebracht, und die Amplitude, Frequenz und Phasenlage wird über geeignete Algorithmen (s.u.) berechnet. Die Maschinenschwingungen werden auf diese Art stark reduziert. Allerdings werden z.T. große Kräfte ins Fundament eingeleitet, die dieses - je nach Bauweise - wiederum zu Schwingungen anregen können.
3. Mischformen:
   Über eine geeignete Qualitätsfunktion wird eine vorteilhafte Kombination aus Entkopplung und Beruhigung ermittelt. Beispielsweise kann es Ziel sein, eine Maschinenschwingungsamplitude unterhalb eines bestimmten Grenzwertes zu halten, dies jedoch bei geringstmöglicher Krafteinleitung in ein Fundament der Maschine. Dies kann abhängig vom Betriebspunkt (etwa Drehfrequenz, anliegendem Drehmoment) erfolgen, entweder durch einen geeigneten adaptiven Algorithmus oder ein Vorsteuerung.

Im Regelfall sind mehrere Piezosteller mit eingangsseitigen Faltenbälgen oder Kolbenkammern mit darin geführten Kolben angebunden. Alle Piezosteller sind dabei bevorzugt gleichförmig ansteuerbar, so dass in Summe mit n Piezostellern eine n-fache Auslenkung des Hubsystems bei gleieher Kraft erzielt werden kann. Diese Anordnung ermöglicht es, für eine ganze Serie von Hubsystemen und erfindungsgemäßen Schwingungsdämpfern ein Gleichteilekonzept zu verfolgen, d.h. die gleichen Piezosteller zu verwenden. Außerdem wird die Ausfallsicherheit des erfindungsgemäßen Hubsystem sowie des erfindungsgemäßen Schwingungsdämpfers erhöht, da bei Ausfall eines einzigen Piezostellers das gesamte Hubsystem oder der gesamte Schwingungsdämpfer, wenn auch mit reduzierter Leistung, weiter arbeitet.

Zur Ansteuerung mehrerer vorhandener erfindungsgemäßer Schwingungsdämpfer eines erfindungsgemäßen Maschinenaggregats ist im Allgemeinen eine verteilte Steuerung notwendig. Hierfür bieten sich bekannte Algorithmen wie der Skyhook-Algorithmus oder der filtered-x LMS-Algorithmus an.

Als einfache Alternative bietet sich an, aus Messwerten ein Maschinenmodell zu erstellen, das eine Vorhersage des zu erwartenden Schwingungsverhaltens bei einer bestimmten Frequenz ermöglicht. Auf dieser Basis lassen sich Amplituden und Phasen der einzelnen Schwingungsdämpfer errechnen, die dann lediglich drehwinkelsynchron gesteuert werden müssen. Der Drehwinkel des Motors lässt sich aus der Ansteuerung (Inverter) des Motors entnehmen, so dass sich auf diese Weise eine einfache und robuste Ansteuerung der Schwingungsdämpfer realisieren lässt.

Nachfolgend wird die Erfindung anhand eines in der Zeichnung dargestellten Ausführungsbeispiels näher erläutert:
Es zeigen:
- Fig. 1: ein Hubsystem, welches einen hydraulischen Wegübersetzer mit hydraulisch miteinander verbundenen Kolbenkammern aufweist, in einer Prinzipskizze im Längsschnitt,
- Fig. 2: einen erfindungsgemäßen Schwingungsdämpfer, welcher zur Schwingungsdämpfung eines Elektromotors ausgebildet ist, in einer Prinzipskizze im Längsschnitt sowie
- Fig. 3: eine konventionelle Maschine (a) und ein erfindungsgemäßes (b) Maschinenaggregat mit einem erfindungsgemäßen Schwingungsdämpfer gem. Fig. 2 in einer Prinzipskizze im Längsschnitt.

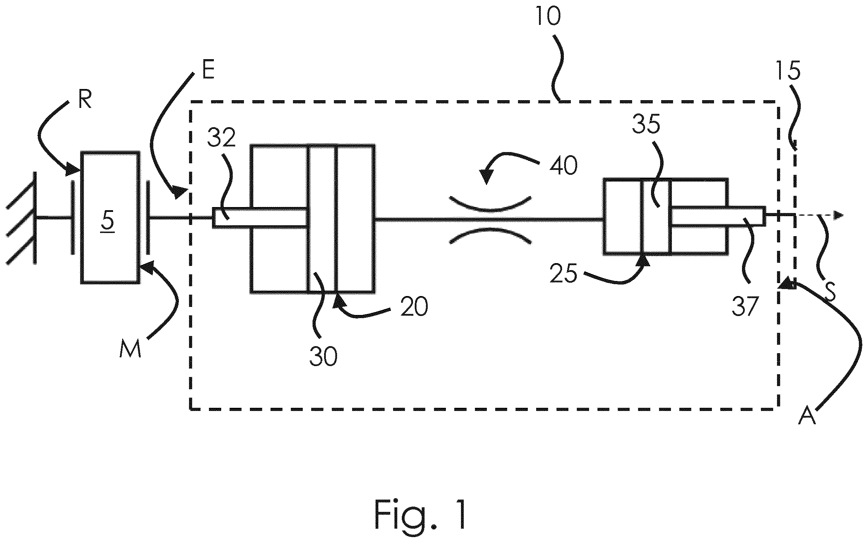

Das in Figur 1 dargestellte dem erfindungsgemäßen Schwingungsdämpfer zugrundeliegende Hubsystem weist einen Piezosteller 5 auf, der zur Stellung eines Stellwegs in Richtung einer Stellrichtung S ausgebildet ist. Dazu ist der Piezosteller 5 an einer Seite R fix eingespannt. Von dieser Seite R streckt sich der Piezosteller 5 in Stellrichtung S mit elektrisch beeinflussbarem Längsmaß in Längsrichtung fort. Der Piezosteller 5 weist somit von seiner eingespannten Seite R abgewandt ein freies Ende M auf, welches von der eingespannten Seite R in Längsrichtung variabel beabstandet ist. Das freie Ende M des Piezostellers 5 ist an eine Eingangsseite E eines hydraulischen Wegübersetzers 10 angebunden.

Der Wegübersetzer 10 weist eine Ausgangsseite A auf, welche an eine Auflage in Gestalt einer Hubtischplatte 15 angebunden ist. Die Hubtischplatte 15 ist in Figur 1 lediglich angedeutet (als gestrichelte, vertikale Linie).

Der hydraulische Wegübersetzer 10 umfasst eine eingangsseitige Kolbenkammer 20 und mit dieser hydraulisch gekoppelt eine ausgangsseitige Kolbenkammer 25. In der eingangsseitigen Kolbenkammer 20 ist ein Kolben 30 eingangsseitig betätigbar geführt, d.h. eine Handhabe 32 ist aus der Kolbenkammer 20 eingangsseitig herausgeführt. In der ausgangsseitigen Kolbenkammer 25 ist ebenfalls ein Kolben 35 geführt. Der Kolben 35 weist eine Handhabe 37 auf, welche ausgangsseitig aus der Kolbenkammer 25 ausgeführt ist. Sowohl der Kolben 30 der eingangsseitigen Kolbenkammer 20 als auch der Kolben 35 in der ausgangsseitigen Kolbenkammer 25 sind jeweils in und entgegengesetzt zur Stellrichtung S in der jeweiligen Kolbenkammer 20, 25 beweglich geführt.

Die eingangsseitige Kolbenkammer 20 und die ausgangsseitige Kolbenkammer 25 sind über eine hydraulische Drossel 40 miteinander hydraulisch verbunden und somit gekoppelt.

Das in Figur 1 dargestellte Hubsystem wird wie folgt betrieben:
Der Piezosteller 5 wird in an sich bekannter Weise mit einer Spannung beaufschlagt, sodass sich das freie Ende M des Piezostellers 5 in Stellrichtung S hin auslenkt. Das freie Ende M des Piezostellers 5 ist mit der Handhabe 32 des in der eingangsseitigen Kolbenkammer 20 geführten Kolbens 30 starr bewegungsgekoppelt. Infolgedessen wird bei der Auslenkung des freien Endes M des Piezostellers 5 der Kolben 30 in Stellrichtung S innerhalb der eingangsseitigen Kolbenkammer 20 bewegt.

In der eingangsseitigen Kolbenkammer 20 ist an der vom Piezosteller 5 abgewandten Seite des Kolbens 30 ein Hydrauliköl befindlich. Der Kolben 30 begrenzt in der eingangsseitigen Kolbenkammer 20 folglich das Volumen, welches das Hydrauliköl in der eingangsseitigen Kolbenkammer 20 einnimmt. Bei der Bewegung des Kolbens 30 in der eingangsseitigen Kolbenkammer 20 in Stellrichtung S verringert sich folglich das für das Hydrauliköl innerhalb der eingangsseitigen Kolbenkammer 20 zur Verfügung stehende Volumen. Infolgedessen wird Hydrauliköl aus der eingangsseitigen Kolbenkammer 20 verdrängt und gelangt über die hydraulische Drossel 40 in die ausgangsseitige Kolbenkammer 25 des hydraulischen Wegübersetzers 10. Auch in der ausgangsseitigen Kolbenkammer 25 wird das für das Hydrauliköl zur Verfügung stehende Volumen durch einen Kolben, hier dem in der ausgangsseitigen Kolbenkammer 25 geführten Kolben 35, begrenzt. In Folge des in die ausgangsseitige Kolbenkammer 25, welche ebenfalls mit Hydrauliköl gefüllt ist, zusätzlich einfließenden Hydrauliköls wird folglich der in der ausgangsseitigen Kolbenkammer 25 geführte Kolben 35 in Stellrichtung S bewegt.

An der Handhabe 37 des in der ausgangsseitigen Kolbenkammer 25 geführten Kolbens 35, welcher in Stellrichtung S bewegt wird, ist die Hubtischplatte 15 starr bewegungsgekoppelt und zwar im gezeigten Ausführungsbeispiel direkt befestigt. Folglich bewegt sich die Hubtischplatte 15 in Stellrichtung S.

In Folge des deutlich größeren Querschnitts senkrecht zur Stellrichtung S der eingangsseitigen Kolbenkammer 20 im Vergleich zur ausgangsseitigen Kolbenkammer 25 bewegt sich die Hubtischplatte 15 nicht etwa um denjenigen Stellweg, um welchen sich das freie Ende M des Piezostellers 5 in Stellrichtung S bewegt (im dargestellten Ausführungsbeispiel ca. 50 pm). Vielmehr weist der hydraulische Wegübersetzer 10 eine deutlich größere Übersetzung auf. Infolgedessen bewegt sich die Hubtischplatte 15 um einen Weg in Stellrichtung S, welcher aus dem Stellweg des freien Endes M des Piezostellers 5 durch Multiplikation mit einem Übersetzungsfaktor > 1 hervorgeht, im dargestellten Ausführungsbeispiel ein Faktor von 100 (die Dimensionen der in Fig. 1 gezeigten Kolbenkammern 20, 25 sind nicht maßstabsgerecht dargestellt). Auf diese Weise lässt sich durch entsprechende Ansteuerung des Piezostellers 5 ein entsprechender Stellweg der Hubtischplatte 15, im dargestellten Ausführungsbeispiel 5 Millimeter, erreichen.

Wird hingegen das freie Ende M des Piezostellers 5 entgegen der Stellrichtung S bewegt, so bewegt sich auch die Hubtischplatte 15 um diesen mit dem Übersetzungsfaktor 100 skalierten Stellweg entgegen der Stellrichtung S.

Bei dem beispielhaften, nicht erfindungsgemäßen Verfahren zur elektrischen Prüfung einer Leuchtdiode ist das in Figur 1 dargestellte Hubsystem derart positioniert, dass die Stellrichtung S parallel oder antiparallel zu derjenigen Richtung, entlang welcher die Gewichtskraft wirkt, orientiert ist. D.h. das in Figur 1 dargestellte Hubsystem ist mit seiner Stellrichtung S vertikal orientiert, beispielsweise derart, dass die Hubtischplatte 15 oberhalb des Piezostellers 5 gelegen ist.

Zur Prüfung der Leuchtdiode wird die Leuchtdiode auf die Hubtischplatte 15 aufgelegt. Zur elektrischen Prüfung der Leuchtdiode wird ein in Figur 1 nicht explizit gezeigter Prüfkontakt, welcher starr zum eingespannten Ende R des Piezostellers 5 angeordnet ist, herangezogen. Die in Figur 1 nicht explizit gezeigte Leuchtdiode wird zur Positionierung relativ zu diesem Prüfkontakt mittels der Hubtischplatte 15 geeignet angehoben oder gesenkt. Auf diese Weise wird die Leuchtdiode mit dem Prüfkontakt in Kontakt gebracht und dabei mit einer Prüfspannung beaufschlagt. Nachfolgend kann eine elektrische Prüfung der Leuchtdiode erfolgen.

Es versteht sich, dass anstelle der eingangsseitigen Kolbenkammer 20 mit dem darin geführten Kolben 30 und der ausgangsseitigen Kolbenkammer 25 mit dem darin geführten Kolben 35 auch ein eingangsseitiger Faltenbalg sowie ein ausgangsseitiger Faltenbalg, die vergleichbar mit der in Figur 1 dargestellten Anordnung über eine hydraulische Drossel 40 miteinander hydraulisch gekoppelt sind, vorhanden sein können. Anstelle der Ankopplung des freien Endes M des Piezostellers 5 an die Handhabe 32 des in der eingangsseitigen Kolbenkammer 20 geführten Kolbens 30 ist das freie Ende des Piezostellers 5 stattdessen an das dem freien Ende des Piezostellers 5 zugewandte Ende des eingangsseitigen Faltenbalgs gekoppelt. Der eingangsseitige Faltenbalg weist dabei eine Faltrichtung auf, welche entlang der Stellrichtung S gem. Fig. 1 verläuft. Entsprechend ist ein der Hubtischplatte 15 zugewandtes Ende des ausgangsseitigen Faltenbalgs an diese angebunden. Die Faltrichtung des ausgangsseitigen Faltenbalges verläuft dabei entgegengesetzt der Stellrichtung S gem. Fig. 1. Es versteht sich ferner, dass bei dem zuvor erläuterten nicht erfindungsgemäßen Verfahren anstelle einer Leuchtdiode auch andere elektronische Komponenten elektrisch geprüft werden können.

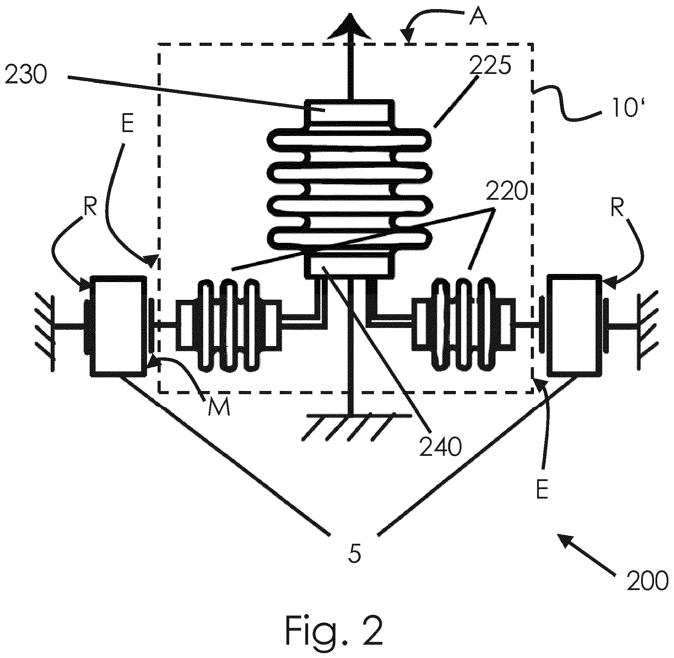

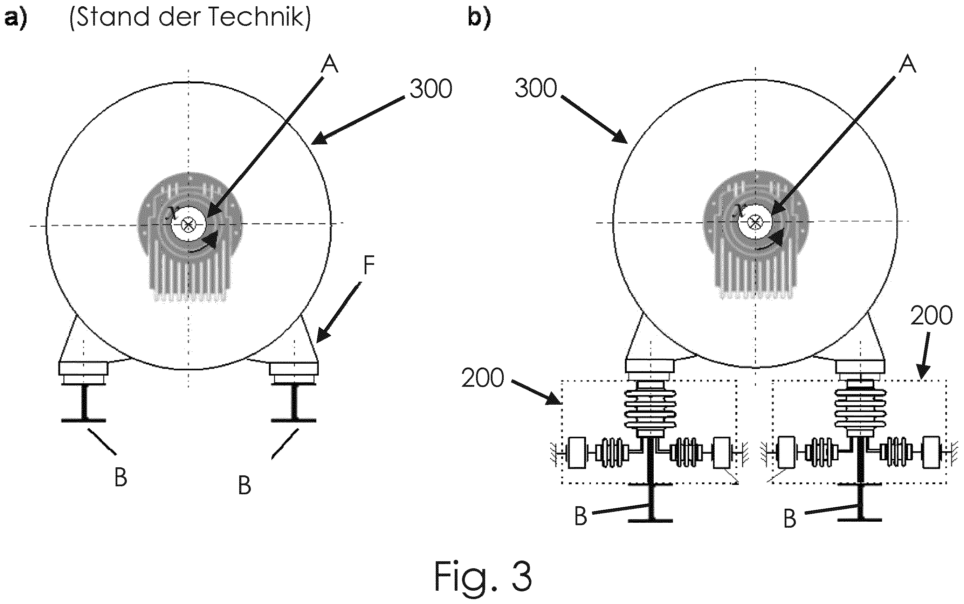

Der in Fig. 2 dargestellte erfindungsgemäße Schwingungsdämpfer 200 dient zur Dämpfung von Schwingungen einer Maschine, in der Darstellung gem. Fig. 3 eines Elektromotors 300.

Der Schwingungsdämpfer 200 umfasst vier Piezosteller 5, welche jeweils an einer Seite R fix eingespannt sind (in der Darstellung gem. Fig. 2 sind von diesen nur zwei Piezosteller 5 gezeigt). Von dieser Seite R streckt sich der Piezosteller 5 jeweils in Stellrichtung S mit elektrisch beeinflussbarem Längsmaß in Längsrichtung fort. Der Piezosteller 5 weist somit jeweils von seiner eingespannten Seite R abgewandt ein freies Ende M auf, welches von der eingespannten Seite R in Längsrichtung variabel beabstandet ist. Das jeweils freie Ende M des jeweiligen Piezostellers 5 ist an eine Eingangsseite E eines hydraulischen Wegübersetzers 10' angebunden. Die vier Piezosteller 5 werden mittels einer Steuereinrichtung (s.u.) synchron ausgelenkt.

Im Unterschied zum in Fig. 1 dargestellten Beispiel umfasst der in Fig. 2 dargestellte hydraulische Wegübersetzer 10' zum einen anstelle einer eingangsseitigen Kolbenkammer 20 mit darin geführtem Kolben 30 einen eingangsseitigen Faltenbalg 220 und anstelle einer ausgangsseitiger Kolbenkammer 25 mit darin geführtem Kolben 35 einen ausgangsseitiger Faltenbalg 225, der mit dem eingangsseitigen Faltenbalg 220 vergleichbar mit der in Figur 1 dargestellten Anordnung über eine hydraulische Drossel 40 miteinander hydraulisch gekoppelt ist.

In einem weiteren Unterschied zum in Fig. 1 dargestellten hydraulischen Wegübersetzer 10 sind im in Fig. 2 dargestellten hydraulischen Wegübersetzer 10' nicht allein einer, sondern vielmehr vier eingangsseitige Faltenbälge 220 jeweils mit einem einzigen ausgangsseitigen Faltenbalg 225 hydraulisch verbunden: Der ausgangsseitige Faltenbalg 225 ist dazu in vertikaler Richtung beweglich, d.h. der ausgangsseitige Faltenbalg 225 ist in vertikaler Richtung zusammenlegbar. Die sich vertikal nach oben streckende Seite des ausgangsseitigen Faltenbalgs 225 schließt stirnseitig mit einer Maschinenauflage 230 ab. Die Maschinenauflage 230 dient als Auflagefläche eines Motorfußes F des Elektromotors 300 (s. insbesondere Fig. 3). Ferner weist die Maschinenauflage 230 ein Gewinde (nicht eigens dargestellt) auf, welches mit einem Gewinde des Motorfußes F korrespondiert, auf. Mittels dieses Gewindes lässt sich der Motorfuß F auf der Maschinenauflage 230 fixieren.

Die eingangsseitigen Faltenbälge 220 sind im Gegensatz zum ausgangsseitigen Faltenbalg 225 horizontal beweglich, d.h. die eingangsseitigen Faltenbälge 220 sind in horizontaler Richtung zusammenlegbar. Die vier eingangsseitigen Faltenbälge 220 strecken sich mit ihren horizontalen Richtungen, in denen diese jeweils beweglich/zusammenlegbar sind, senkrecht auf die horizontale Ebene betrachtet sternartig radial vom ausgangsseitigen Faltenbalg 225 weg.

Die ausgangsseitigen Faltenbälge 220 stützen sich gegenüber einem Fundament B ab.

Das in Fig. 3b dargestellte erfindungsgemäße Maschinenaggregat (im Gegensatz zu einer konventionellen Maschine a)) umfasst den Elektromotor 300 mit vier Motorfüßen F sowie die vier Schwingungsdämpfer 200, an welchen jeder der vier Motorfüße des Elektromotors 300 angebundenen ist.

Der Elektromotor 300 umfasst eine Stator sowie einen Rotor (nicht im Einzelnen gezeigt), welcher gegenüber dem Stator (nicht im Einzelnen dargestellt) mit einer Frequenz bis hin zu einer Maximalbetriebsfrequenz von 5000 Umdrehungen je Minute um eine Achse A rotiert. Der Elektromotor 300 weist 2 Polpaare (nicht explizit gezeigt) auf, sodass die im Betrieb maximal auftretende Maximalfrequenz von Schwingungen 10000 1/min beträgt. Ferner treten beim Betrieb des Motors im Frequenzbereich von 0 bis 10000 1/min Maximalauslenkungen von 800 Mikrometern auf.

Dazu weist der erfindungsgemäße Schwingungsdämpfer 200 Kraftsensoren (nicht eigens dargestellt) auf, welche jeweils eingangsseitig am ausgangsseitigen Faltenbalg 225 angeordnet sind und dort angreifende Kräfte erfassen. Mittels der Kraftsensoren wird die jeweils wirkende Kraft erfasst und einer Steuereinrichtung (nicht eigens gezeigt) übermittelt. Mittels der Steuereinrichtung werden die Piezosteller 5 in ihrer zeitlichen Auslenkung derart angesteuert, dass die jeweils wirkende Kraft möglichst verschwindet.

Alternativ können in einem weiteren, nicht eigens dargestellten Ausführungsbeispiel anstelle der Kraftsensoren Beschleunigungssensoren vorgesehen sein, welche jeweils an den Motorfüßen F oder an dem Rotor des Elektromotors 300 angeordnet sind und welche die Schwingungen des Elektromotors 300 in Amplitude, Frequenz und Phase erfassen. Die Sensoren übermitteln die erfassten Daten an eine Steuereinrichtung, welche die Piezosteller 5 derart ansteuert, dass die (räumliche) Amplitude der Motorschwingungen möglichst verschwindet.

In einem weiteren Ausführungsbeispiel sind ferner Mischformen der beiden vorgenannten Ansteuerungen möglich: So kann eine geeignete Qualitätsfunktion vorgesehen sein, deren Berücksichtigung dazu führt, dass beispielsweise eine Amplitude der Motorschwingungen unterhalb eines bestimmten Schwellwertes gehalten wird, während dies bei geringstmöglicher Krafteinwirkung ins Fundament B erfolgt.

In einem weiteren, nicht eigens dargestellten Ausführungsbeispiel, welches im Übrigen dem dargestellten Ausführungsbeispiel entspricht, ist zusätzlich ein Anbindungsstück zur Anbindung an den Elektromotor 30 sowie ein zusätzlicher, zweiter hydraulischer Wegübersetzer vorgesehen, welcher eine Eingangsseite aufweist, die an einen weiteren Linearaktor, sowie eine Ausgangsseite, die an das Anbindungsteil angebunden ist, aufweist.

Die Steuerung der vier Schwingungsdämpfer 200 erfolgt in den vorgenannten Ausführungsbeispielen mittels einer verteilten Steuerung: beispielsweise wird dabei der Skyhook-Algorithmus oder der filtered-x LMS-Algorithmus eingesetzt.

Alternativ wird in einem weiteren Ausführungsbeispiel ein Maschinenmodell für den Elektromotor 300 herangezogen, welches eine Vorhersage des zu erwartenden Schwingungsverhaltens bei einer bestimmten Frequenz ermöglicht. Auf dieser Basis lassen sich die einzustellenden Amplituden und Phasen der einzelnen Schwingungsdämpfer errechnen, die dann lediglich drehwinkelsynchron mit der Betriebsfrequenz des Elektromotors 300 gesteuert werden müssen. Der Drehwinkel des Elektromotors 300 lässt sich aus der Ansteuerung, etwa einem Inverter (nicht gezeigt) des Elektromotors 300 entnehmen, so dass sich auf diese Weise eine einfache und robuste Ansteuerung der Piezosteller 5 realisieren lässt.

## Patentansprüche

1. Schwingungsdämpfer, welcher ein Hubsystem aufweist, das zumindest einen Piezosteller (5), eine Auflage (15) sowie einen hydraulischen Wegübersetzer (10) mit einer Eingangs- und einer Ausgangsseite aufweist, welcher mit seiner Eingangsseite an den Piezosteller (5) und mit seiner Ausgangsseite an die Auflage (15) angebunden ist, wobei der Schwingungsdämpfer eine Steuereinheit aufweist, welche ausgebildet ist, den Piezosteller in einer ersten Betriebsart derart anzusteuern, dass die insgesamt auf das Hubsystem wirkende Kraft konstant bleibt und/oder in einer zweiten Betriebsart derart zu steuern, dass die Auflage mit möglichst geringer Auslenkung schwingt.

2. Schwingungsdämpfer nach Anspruch 1, bei welchem der hydraulische Wegübersetzer (10) ein- und ausgangsseitig jeweils mindestens eine Kolbenkammer (20, 25) sowie einen darin geführten Kolben (30, 35) umfasst, wobei die Querschnitte der ein- und der ausgangsseitigen Kolbenkammer/n (30, 35) vorzugsweise voneinander abweichen.

3. Schwingungsdämpfer nach einem der vorhergehenden Ansprüche, bei welchem der hydraulische Wegübersetzer (10) ein- und ausgangsseitig jeweils zumindest einen Faltenbalg umfasst, wobei die Querschnitte des/der ein- und des ausgangsseitigen Faltenbalgs/-bälge voneinander abweichen.

4. Schwingungsdämpfer nach einem der vorhergehenden Ansprüche, bei welchem der hydraulische Wegübersetzer eingangsseitig zwei oder drei oder vier oder mehr Elemente aufweist aus der einen Faltenbalg sowie eine Kolbenkammer mit darin geführtem Kolben umfassenden Gruppe, wobei der hydraulische Wegübersetzer ausgangsseitig weniger Elemente aus der vorgenannten Gruppe, vorzugsweise genau ein Element, aufweist.

5. Schwingungsdämpfer nach einem der vorhergehenden Ansprüche, bei welchem ein- und ausgangsseitige Kolbenkammer/n (20, 25) oder ein- und ausgangsseitiger Faltenbalg/-bälge miteinander hydraulisch verbunden sind.

6. Schwingungsdämpfer nach einem der vorhergehenden Ansprüche, bei welchem ein- und ausgangsseitiger Faltenbalg/-bälge oder ein- und ausgangsseitige Kolbenkammer/n (20, 25) miteinander mittels einer/mehrerer hydraulischen Drossel/n (40) verbunden sind.

7. Schwingungsdämpfer nach einem der vorhergehenden Ansprüche, bei welchem der Querschnitt der eingangsseitigen Kolbenkammer (20) größer ist als der Querschnitt der ausgangsseitigen Kolbenkammer (25) oder bei welchem der Querschnitt des eingangsseitigen Faltenbalgs größer ist als der Querschnitt des ausgangsseitigen Faltenbalgs.

8. Schwingungsdämpfer nach einem der vorhergehenden Ansprüche, bei welchem die Auflage zur form- und/oder stoff- und/oder kraftschlüssigen Verbindung mit einem Teil einer Maschine, insbesondere einem Maschinenfuß, eingerichtet ist.

9. Schwingungsdämpfer nach einem der vorhergehenden Ansprüche, welcher zudem einen Linearaktor, ein Anbindungsstück sowie einen zweiten hydraulischen Wegübersetzer (10) mit einer Eingangs- und einer Ausgangsseite, welcher mit seiner Eingangsseite an den Linearaktor und mit seiner Ausgangsseite an das Anbindungsstück angebunden ist, aufweist.

10. Schwingungsdämpfer nach einem der vorhergehenden Ansprüche, bei welchem anstelle eines Piezostellers ein sonstiger Aktor, insbesondere ein magnetischer und/oder magnetostriktiver und/oder elektrostriktiver Aktor und/oder ein Aktor, welcher auf dem Formgedächtnis-Prinzip, vorzugsweise dem Prinzip des magnetischen Formgedächtnisses, beruht, vorhanden ist.

11. Maschinenaggregat, aufweisend eine Maschine, insbesondere einen Elektromotor, sowie mindestens einen Schwingungsdämpfer nach einem der vorhergehenden Ansprüche, welcher, vorzugsweise mittels eines Anbindungsteils, an die Maschine, vorzugsweise zumindest einen Fuß der Maschine, angebunden ist.

## Claims

1. Vibration damper which has a lifting system which has at least one piezo actuator (5), a support (15), and a hydraulic stroke multiplier (10) with an input and an output side, which hydraulic stroke multiplier is attached by way of its input side to the piezo actuator (5) and by way of its output side to the support (15), wherein the vibration damper has a control unit which is designed to control the piezo actuator in a first operating mode such that the total force acting on the lifting system remains constant, and/or to control the piezo actuator in a second operating mode such that the support vibrates with the least possible deflection.

2. Vibration damper according to Claim 1, in which the hydraulic stroke multiplier (10) comprises, at the input side and at the output side, in each case at least one piston chamber (20, 25) and a piston (30, 35) guided therein, wherein the cross sections of the input-side and of the output-side piston chamber(s) (30, 35) preferably differ from one another.

3. Vibration damper according to either of the preceding claims, in which the hydraulic stroke multiplier (10) comprises, at the input side and at the output side, in each case at least one corrugated bellows, wherein the cross sections of the one or more input-side and output-side corrugated bellows differ from one another.

4. Vibration damper according to any of the preceding claims, in which the hydraulic stroke multiplier has, at the input side, two or three or four or more elements from the group comprising a corrugated bellows and a piston chamber with piston guided therein, wherein the hydraulic stroke multiplier has, at the output side, fewer elements from the abovementioned group, preferably precisely one element.

5. Vibration damper according to any of the preceding claims, in which input-side and output-side piston chamber(s) (20, 25) or one or more input-side and output-side corrugated bellows are hydraulically connected to one another.

6. Vibration damper according to any of the preceding claims, in which one or more input-side and output-side corrugated bellows or input-side and output-side piston chamber(s) (20, 25) are connected to one another by way of one or more hydraulic throttle(s) (40).

7. Vibration damper according to any of the preceding claims, in which the cross section of the input-side piston chamber (20) is greater than the cross section of the output-side piston chamber (25), or in which the cross section of the input-side corrugated bellows is greater than the cross section of the output-side corrugated bellows.

8. Vibration damper according to any of the preceding claims, in which the support is designed for positively locking and/or cohesive and/or non-positively locking connection to a part of a machine, in particular to a machine foot.

9. Vibration damper according to any of the preceding claims, which furthermore has a linear actuator, an attachment piece and a second hydraulic stroke multiplier (10) with an input and an output side, which second hydraulic stroke multiplier is attached by way of its input side to the linear actuator and by way of its output side to the attachment piece.

10. Vibration damper according to any of the preceding claims, in which, instead of a piezo actuator, some other actuator is provided, in particular a magnetic and/or magnetostrictive and/or electrostrictive actuator and/or an actuator which is based on the shape memory principle, preferably on the principle of magnetic shape memory.

11. Machine assembly having a machine, in particular an electric motor, and having at least one vibration damper according to any of the preceding claims, which at least one vibration damper is attached, preferably by way of an attachment part, to the machine, preferably to at least one foot of the machine.

## Revendications

1. Amortisseur de vibrations, qui a un système de levage, qui a au moins un régulateur (5) piézoélectrique, un appui (15) ainsi qu'un intensificateur (10) hydraulique de chemin ayant un côté d'entrée et un côté de sortie, qui par son côté d'entrée est relié au régulateur (5) piézoélectrique et par son côté de sortie à l'appui (15), l'amortisseur de vibrations ayant une unité de commande, qui est constituée pour commander le régulateur piézoélectrique dans un premier type de fonctionnement, de manière à ce que la force appliquée dans l'ensemble au système de levage reste constante et/ou à le commander dans un deuxième type de fonctionnement, de manière à ce que l'appui oscille avec une excursion aussi petite que possible.

2. Amortisseur de vibrations suivant la revendication 1, dans lequel l'intensificateur (10) hydraulique de chemin comprend du côté de l'entrée et du côté de la sortie respectivement au moins une chambre (20, 25) à piston ainsi qu'un piston (30, 35) qui y passe, les sections transversales de la chambre ou des chambres (30, 35) du côté de l'entrée et du côté de la sortie étant différentes de préférence l'une de l'autre.

3. Amortisseur de vibrations suivant l'une des revendications précédentes, dans lequel l'intensificateur (10) hydraulique de chemin comprend du côté de l'entrée et du côté de la sortie respectivement au moins un soufflet à plis, les sections transversales du soufflet à plis /des soufflets à plis du côté de l'entrée et du côté de la sortie étant différentes l'une de l'autre.

4. Amortisseur de vibrations suivant l'une des revendications précédentes, dans lequel l'intensificateur hydraulique de chemin a du côté de l'entrée deux ou trois ou quatre ou plusieurs éléments du groupe comprenant un soufflet à plis ainsi qu'une chambre à piston avec un piston qui y passe, l'intensificateur de chemin ayant du côté de la sortie moins d'éléments dudit groupe, de préférence exactement un élément.

5. Amortisseur de vibrations suivant l'une des revendications précédentes, dans lequel une chambre/des chambres (20, 25) à piston du côté de l'entrée et du côté de la sortie ou un soufflet à plis/des soufflets à plis du côté de l'entrée et du côté de la sortie communiquent entre eux hydrauliquement.

6. Amortisseur de vibrations suivant l'une des revendications précédentes, dans lequel un soufflet à plis/des soufflets à plis du côté de l'entrée et du côté de la sortie où une chambre/des chambres (20, 25) à piston du côté de l'entrée et du côté de la sortie communiquent entre eux au moyen d'un étranglement ou de plusieurs étranglements hydrauliques.

7. Amortisseur de vibrations suivant l'une des revendications précédentes, dans lequel la section transversale de la chambre (20) à piston du côté de l'entrée est plus grande que la section transversale de la chambre (25) à piston du côté de la sortie ou dans lequel la section transversale du soufflet à plis du côté de l'entrée est plus grande que la section transversale du soufflet à plis du côté de la sortie.

8. Amortisseur de vibrations suivant l'une des revendications précédentes, dans lequel l'appui est conçu pour la liaison à complémentarité de forme et/ou à coopération de matière et/ou à coopération de force avec une partie d'une machine, notamment d'un pied de machine.

9. Amortisseur de vibrations suivant l'une des revendications précédentes, qui a, en outre, un actionneur linéaire, une pièce de liaison, ainsi qu'un deuxième intensificateur (10) hydraulique de chemin ayant un côté d'entrée et un côté de sortie, qui est relié par son côté d'entrée à l'actionneur linéaire et par son côté de sortie à la pièce de liaison.

10. Amortisseur de vibrations suivant l'une des revendications précédentes, dans lequel au lieu d'un régulateur piézoélectrique il y a un autre actionneur, notamment un actionneur magnétique et/ou magnétostrictif et/ou électrostrictif et/ou un actionneur, qui repose sur le principe de la mémoire de forme, de préférence sur le principe de la mémoire de forme magnétique.

11. Groupe de machine, comportant une machine, notamment un moteur électrique, ainsi qu'au moins un amortisseur de vibrations suivant l'une des revendications précédentes, qui est relié, de préférence au moyen d'une partie de liaison, à la machine, de préférence au moins à un pied de la machine.
